# EUROPEAN PATENT APPLICATION

(11) **EP 4 694 627 A1**
(43) Date of publication of application: **11.02.2026**
(21) Application number: 25179727.0
(22) Date of filing: 29.05.2025
(51) Int. Cl.: H10F 19/90, H10F 77/20

(54) **SOLAR CELL, SOLAR CELL STRING, AND PHOTOVOLTAIC MODULE**

(30) Priority: 05.08.2024 CN 202411068138
(71) Applicant: Tongwei Solar (Chengdu) Co., Ltd., Chengdu, Sichuan 610299 (CN)
(72) Inventor: ZHAO, Zhihao, Chengdu, 610299 (CN); SHEN, Haiping, Chengdu, 610299 (CN); WANG, Tianqi, Chengdu, 610299 (CN); XIA, Zhengyue, Chengdu, 610299 (CN); XING, Guoqiang, Chengdu, 610299 (CN); SUN, Zheng, Chengdu, 610299 (CN)
(74) Representative: Gill Jennings & Every LLP

(57) **Abstract**

The present disclosure provides a solar cell, a solar cell string, and a photovoltaic module. The solar cell includes a cell substrate (100), a solder strip (200) arranged on the cell substrate, and a reinforced limiting adhesive dot (310) and an additional limiting adhesive dot (320) that are attached to the solder strip and the cell substrate. The cell substrate includes an adhesion-enhanced region immediately adj acent to at least one edge of the cell substrate, and an additional region (120) arranged at a side of the adhesion-enhanced region away from the at least one edge. The additional limiting adhesive dot is arranged in the additional region. The reinforced limiting adhesive dot is arranged in the adhesion-enhanced region. An adhesion force between the reinforced limiting adhesive dot and the solder strip is greater than that between the additional limiting adhesive dot and the solder strip.

## Description

### TECHNICAL FIELD

The present disclosure relates to the field of photovoltaic technology, and in particular, to a solar cell, a solar cell string, and a photovoltaic module.

### BACKGROUND

Solar cells are devices capable of converting light energy into electrical energy. The solar cells can achieve effective collection and utilization of solar energy, making them indispensable power generating devices at present. In the conventional structures of the solar cells, in addition to semiconductor material portions that absorb lights and generate photogenerated carriers, grid line electrodes are typically required to collect and export the carriers. The material cost of the grid line electrodes accounts for a significant proportion of the production cost of the solar cells.

The design of structures without main grids, which reduces the consumption of electrode materials by eliminating main grid electrodes, can significantly lower the material cost associated with grid line electrodes and has thus gradually gained attention. However, solar cells without main grids are prone to issues of loose connections during the actual production process, leading to poor reliability of the solar cells and increasing the workload for rework.

### SUMMARY

In view of this, to solve the problems in the background art, there is a need to provide a solar cell that can mitigate or prevent the loose connections, thereby improving the reliability of the solar cell and reducing the workload for rework.

In a first aspect, the present disclosure provides a solar cell, including a cell substrate, a solder strip, a reinforced limiting adhesive dot, and an additional limiting adhesive dot. The solder strip is arranged on the cell substrate. The reinforced limiting adhesive dot and the additional limiting adhesive dot are attached to the solder strip and the cell substrate.

The cell substrate includes an adhesion-enhanced region and an additional region. The adhesion-enhanced region is immediately adjacent to at least one edge of the cell substrate. The additional region is arranged at a side of the adhesion-enhanced region away from the at least one edge. The additional limiting adhesive dot is arranged in the additional region. The reinforced limiting adhesive dot is arranged in the adhesion-enhanced region. An adhesion force between the reinforced limiting adhesive dot and the solder strip is greater than that between the additional limiting adhesive dot and the solder strip.

In some embodiments of the present disclosure, a contact area between the reinforced limiting adhesive dot and the solder strip is greater than that between the additional limiting adhesive dot and the solder strip, such that the adhesion force between the reinforced limiting adhesive dot and the solder strip is greater than that between the additional limiting adhesive dot and the solder strip.

In some embodiments of the present disclosure, a volume of the reinforced limiting adhesive dot is greater than that of the additional limiting adhesive dot.

In some embodiments of the present disclosure, a length of the reinforced limiting adhesive dot is greater than that of the additional limiting adhesive dot, a width of the reinforced limiting adhesive dot is greater than that of the additional limiting adhesive dot, and a height of the reinforced limiting adhesive dot is greater than that of the additional limiting adhesive dot.

In some embodiments of the present disclosure, the additional limiting adhesive dots and the reinforced limiting adhesive dots satisfy at least one of the following conditions:
(1) a ratio of the length of the reinforced limiting adhesive dot to the length of the additional limiting adhesive dot is 1.2 to 2;
(2) a ratio of the width of the reinforced limiting adhesive dot to the width of the additional limiting adhesive dot is 1.2 to 2; and
(3) a ratio of the height of the reinforced limiting adhesive dot to the height of the additional limiting adhesive dot is 1 to 2.

In some embodiments of the present disclosure, the additional limiting adhesive dots satisfy at least one of the following conditions:
(1) a ratio of the length of the additional limiting adhesive dot to a strip width of the solder strip is 1.5 to 6;
(2) a ratio of the width of the additional limiting adhesive dot to the strip width of the solder strip is 0.5 to 3; and
(3) a ratio of the height of the additional limiting adhesive dot to the strip width of the solder strip is 0.5 to 1.2.

In some embodiments of the present disclosure, there are a plurality of solder strips extending in a first direction and arranged side by side in a second direction intersecting with the first direction. The at least one edge of the cell substrate includes two first edges opposite to each other in the first direction and two second edges opposite to each other in the second direction.

The adhesion-enhanced region includes two first sub-regions located immediately adjacent to the two first edges, respectively, and at least one of the two first sub-regions is provided with the reinforced limiting adhesive dot. Additionally or alternatively, the adhesion-enhanced region includes two second sub-regions located immediately adjacent to the two second edges, respectively, and at least one of the two second sub-region is provided with the reinforced limiting adhesive dot.

In some embodiments of the present disclosure, the adhesion-enhanced region includes the two first sub-regions. Each of the plurality of solder strips is attached with the additional limiting adhesive dot and at least two reinforced limiting adhesive dots. The additional limiting adhesive dot is arranged between the two reinforced limiting adhesive dots. The two reinforced limiting adhesive dots are located in the two first sub-regions, respectively.

Alternatively, the adhesion-enhanced region includes the two second sub-regions. Each of the two second sub-regions is provided with at least one solder strip. Each of the at least one solder strip in each of the two second sub-regions is attached with a plurality of reinforced limiting adhesive dots.

In some embodiments of the present disclosure, the adhesion-enhanced region includes the two first sub-regions and the two second sub-region. The two second sub-regions are located between the two first sub-regions.

Each of the two first sub-regions is provided with at least one solder strip, and each of the at least one solder strip in each of the two second sub-regions is attached with a plurality of reinforced limiting adhesive dots.

The solder strip located between the two second sub-regions is attached with the additional limiting adhesive dot and at least two reinforced limiting adhesive dots. The additional limiting adhesive dot is arranged between the two reinforced limiting adhesive dots. The two reinforced limiting adhesive dots are located in the two first sub-regions, respectively.

In some embodiments of the present disclosure, the plurality of reinforced limiting adhesive dots includes a first reinforced adhesive dot arranged in the first sub-region and a second reinforced adhesive dot arranged in the second sub-region, and an adhesion force between the first reinforced adhesive dot and the solder strip is different from that between the second reinforced adhesive dot and the solder strip.

In some embodiments of the present disclosure, the first reinforced adhesive dot and the second reinforced adhesive dot satisfy at least one of the following conditions:
(1) a length of the first reinforced adhesive dot is greater than that of the second reinforced adhesive dot;
(2) a width of the first reinforced adhesive dot is greater than that of the second reinforced adhesive dot; and
(3) a height of the first reinforced adhesive dot is greater than that of the second reinforced adhesive dot.

In some embodiments of the present disclosure, a plurality of limiting adhesive dots are arranged on the cell substrate in an array in the first direction and the second direction. One or more rows of limiting adhesive dots located immediately proximate to the first edge are arranged in the first sub-region. One or more columns of limiting adhesive dots located between the two first sub-regions and immediately proximate to the second edge are arranged in the second sub-region.

In some embodiments of the present disclosure, the cell substrate includes a welding electrode. The welding electrode is arranged below the solder strip and extend in an extension direction of the solder strip. A width of the welding electrode is 50 µm to 55 µm.

In some embodiments of the present disclosure, a material of the reinforced limiting adhesive dot is the same as that of the additional limiting adhesive dot.

In some embodiments of the present disclosure, cell substrate comprises a fine grid electrode extending in a direction intersecting with an extension direction of the solder strip.

In some embodiments of the present disclosure, a plurality of solder strips parallel to and spaced from each other are arranged on the cell substrate, and each of two end portions of each of the plurality of solder strips is provided with the reinforced limiting adhesive dot.

In some embodiments of the present disclosure, each of the plurality of solder strips is provided with a plurality of additional limiting adhesive dots arranged spaced apart in an extension direction thereof and located between the two end portions thereof.

In some embodiments of the present disclosure, a plurality of solder strips parallel to and spaced from each other are arranged on the cell substrate, and two of the plurality of solder strips located at opposite edges of the cell substrate are each provided with a plurality of reinforced limiting adhesive dots spaced from each other in an extension direction thereof.

In some embodiments of the present disclosure, others of the plurality of solder strips are each provided with a plurality of additional limiting adhesive dots spaced from each other in an extension direction thereof.

In a second aspect, the present disclosure further provides a solar cell string, including a plurality of solar cells according to any one of the above embodiments. The solder strips of the solar cells are connected to each other.

In a third aspect, the present disclosure further provides a photovoltaic module, including a first encapsulation panel, a second encapsulation panel, and the solar cell string according to any one of the above embodiments. The solar cell string is arranged between the first encapsulation panel and the second encapsulation panel.

The solar cell includes the adhesion-enhanced region and the additional region respectively provided with the reinforced limiting adhesive dot and the additional limiting adhesive dot. The adhesion force between the reinforced limiting adhesive dot and the solder strip is greater than that between the additional limiting adhesive dot and the solder strip. By establishing a larger adhesion force between the reinforced limiting adhesive dot and the solder strip, the bonding strength between the edge of the cell substrate and the solder strip can be improved, which reduces the risk of detachment between the cell substrate and the solder strip or the solder strip being pushed out of alignment by a molten encapsulant film, thereby increasing the reliability of the solar cell and reducing the workload for rework. Furthermore, the limiting adhesive dot may block light that is incident on the cell substrate. In the solar cell design, having a larger adhesion force between the reinforced limiting adhesive dot and the solder strip, and a smaller adhesion force between the additional limiting adhesive dot and the solder strip, not only ensures the overall structural stability of the solder strip but also ensures that the amount of light received by the solar cell remains substantially unchanged.

The above description is merely a summary of the technical solutions of the present disclosure. To provide a clearer understanding of the technical solutions of the present disclosure, and to enable their implementation in accordance with the content of the specification, a detailed description of the exemplary embodiments of the present disclosure, in conjunction with the accompanying drawings, is provided below.

### BRIEF DESCRIPTION OF THE DRAWINGS

FIG. 1 is a schematic top view of a structure of a solar cell according to an embodiment;
FIG. 2 is a schematic view of a partially enlarged structure including a solder strip, a reinforced limiting adhesive dot, and an additional limiting adhesive dot in FIG. 1;
FIG. 3 is a schematic top view of a structure of a solar cell according to another embodiment;
FIG. 4 is a schematic top view of a structure of a solar cell according to yet another embodiment;
FIG. 5 is a schematic top view of a structure of a solar cell according to yet another embodiment;
FIG. 6 is a diagram showing results of electroluminescence testing on a solar cell string in Comparative Example 1; and
FIG. 7 is a diagram showing results of electroluminescence testing on a solar cell string in Example 1.

Reference numerals and corresponding meanings are as follows:
100-cell substrate; 101-first edge; 102-second edge; 111-first sub-region; 112-second sub-region; 120-additional region; 200-solder strip; 310-reinforced limiting adhesive dot; 311-first reinforced adhesive dot; 312-second reinforced adhesive dot; and 320-additional limiting adhesive dot.

### DETAILED DESCRIPTION

Unless otherwise defined, all technical and scientific terms used herein have the same meanings as commonly understood by those skilled in the technical field to which the present disclosure belongs. Terms used in the specification herein are merely used to describe specific embodiments rather than limit the present disclosure.

It should be understood that when an element or a layer is referred to as being "on", "adjacent to", "connected to", or "coupled to" other elements or layers, the element or the layer may be directly on, directly adjacent to, directly connected to, or directly coupled to the other elements or layers, or there may be intermediate elements or layers. Conversely, when an element is referred to as being "directly on", "directly adjacent to," "directly connected to", or "directly coupled to" other elements or layers, no intermediate elements or layers exist. It should be understood that although terms such as first, second, and third may be used to describe various elements, components, regions, layers, and/or portions, these elements, components, regions, layers, and/or portions should not be limited by these terms. These terms are only used to distinguish one element, component, region, layer, or portion from another element, component, region, layer, or portion.

Spatial relationship terms such as "under", "below", "lower", "beneath", "above", and "upper" may be used herein for ease of description to describe a relationship of one element or feature to another element or feature. It should be understood that the spatial relationship terms are also intended to include different orientations of a device in use and operation. For example, if the device in the accompanying drawings is flipped over, an element or a feature described as being "below other elements" or "under other elements" or "beneath other elements" will be oriented "above other elements or features". Therefore, exemplary terms "below" and "under" may include both upper and lower orientations. The device may be additionally oriented (e.g., rotated by 90 degrees or at other orientations), and spatial descriptors used herein are to be interpreted accordingly.

The terms used herein are only for the purpose of describing specific embodiments and do not serve as limitations of the present disclosure. When used herein, the singular forms "a", "an", and "the" are also intended to include the plural forms, unless the context clearly indicates otherwise. It should also be understood that the terms "composed of" and/or "include", when used in the specification, determine the existence of features, integers, steps, operations, elements, and/or components, but do not exclude the existence or addition of one or more other features, integers, steps, operations, elements, components, and/or groups. When used herein, the term "and/or" includes any and all combinations of related listed items.

In a conventional solar cell, a main grid electrode is typically provided with a solder pad thereon for welding to a solder strip. The welding of the solder pad to the solder strip ensures the positional stability of the solder strip. In designs of a structure without the main grid, the main grid electrode and the solder pad thereon are together eliminated, and the solder strip is directly welded to a fine grid electrode. Since the bonding between the solder strip and the fine grid electrode is unstable, it is typically necessary to apply an adhesive to bond the solder strip to the cell substrate to ensure the positional stability of the solder strip. However, while this method can help fix the position of the solder strip, once the solar cell is connected into a solar cell string and assembled into a photovoltaic module, loose connections tend to occur. At these loose connection points, currents may not fully conduct, leading to noticeable dark areas during electroluminescence testing, which significantly negatively impacts the device's performance, including its efficiency.

Furthermore, the present inventors have found the following reasons through the research: on one hand, during operations such as the layout and transfer of solar cell strings, the gravity of the solar cells can cause the edges of the cell substrates to slightly detach from the solder strips, resulting in loose connections. On the other hand, during the lamination process, the melting and flowing of the encapsulant film can exert lateral forces on the edges of the solder strips. This can cause the solder strips near the edges of the cell substrates to shift, allowing the molten encapsulant film to penetrate between the solder strips and the cell substrates, which also contributes to the problem of loose connections.

In order to solve the above problems, the present disclosure provides a solar cell. The solar cell includes a cell substrate, a solder strip, a reinforced limiting adhesive dot, and an additional limiting adhesive dot. The solder strip is arranged on the cell substrate. The reinforced limiting adhesive dot and the additional limiting adhesive dot are attached to the solder strip and the cell substrate. The cell substrate includes an adhesion-enhanced region and an additional region. The adhesion-enhanced region is located immediately adjacent to at least one edge of the cell substrate. The additional region is arranged at a side of the adhesion-enhanced region away from the at least one edge. The additional limiting adhesive dot is arranged in the additional region. The reinforced limiting adhesive dot is arranged in the adhesion-enhanced region. An adhesion force between the reinforced limiting adhesive dot and the solder strip is greater than that between the additional limiting adhesive dot and the solder strip.

It should be understood that the cell substrate may have a plurality of edges, and the adhesion-enhanced region may be located immediately adjacent to at least one of the edges. Further, the adhesion-enhanced region may be located immediately adjacent to part or all of the at least one of the edges. Further, the adhesion-enhanced region may also be located immediately adjacent to two adjacent edges or two opposite edges. The additional region may be spaced apart from the edges of the cell substrate or may be located immediately adjacent to one or more edges of the cell substrate.

The solar cell includes the adhesion-enhanced region and the additional region respectively provided with the reinforced limiting adhesive dot and the additional limiting adhesive dot. The adhesion force between the reinforced limiting adhesive dot and the solder strip is greater than that between the additional limiting adhesive dot and the solder strip. By establishing a larger adhesion force between the reinforced limiting adhesive dot and the solder strip, the bonding strength between the edge of the cell substrate and the solder strip can be improved, which reduces the risk of detachment between the cell substrate and the solder strip or the solder strip being pushed out of alignment by a molten encapsulant film, thereby increasing the reliability of the solar cell and reducing the workload for rework. Furthermore, the limiting adhesive dot may block light that is incident on the cell substrate. In the solar cell design, having a larger adhesion force between the reinforced limiting adhesive dot and the solder strip, and a smaller adhesion force between the additional limiting adhesive dot and the solder strip, not only ensures the overall structural stability of the solder strip but also ensures that the amount of light received by the solar cell remains substantially unchanged, thereby improving the conversion efficiency of the solar cell.

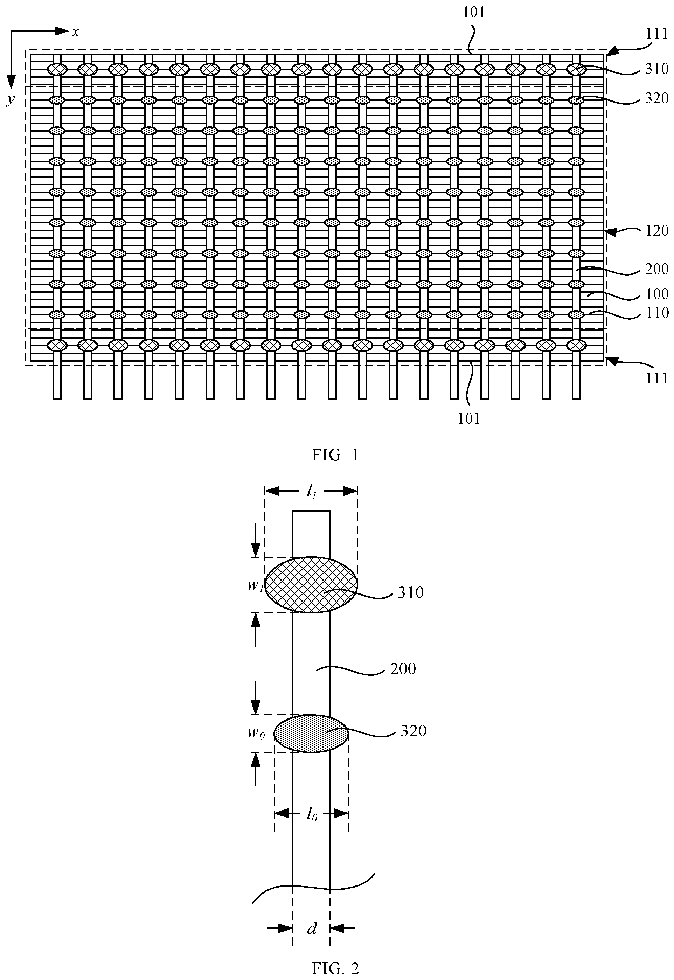

FIG. 1 is a schematic top view of a structure of a solar cell according to an embodiment. Referring to FIG. 1, the solar cell includes a cell substrate 100, a solder strip 200, a reinforced limiting adhesive dot 310, and an additional limiting adhesive dot 320. The solder strip 200 is arranged on the cell substrate 100. The reinforced limiting adhesive dot 310 and the additional limiting adhesive dot 320 are attached to the solder strip 200 and the cell substrate 100.

In some examples of the embodiment, there may be a plurality of solder strips 200. The plurality of solder strips 200 extend in a first direction and are arranged side by side in a second direction intersecting with the first direction. For ease of description, the first direction may be a direction indicated by a y-axis in FIG. 1, and the second direction may be a direction indicated by an x-axis in FIG. 1. In some examples, the first direction and the second direction intersect perpendicularly.

In the embodiment, the cell substrate 100 has two first edges 101 opposite to each other in the first direction. It should be understood that according to the orientation shown in FIG. 1, the two first edges 101 are located on an upper side and a lower side of the cell substrate 100, respectively. Further, an adhesion-enhanced region may include two first sub-regions 111 located immediately adjacent to the two first edges 101, respectively. Each first sub-region 111 may be located immediately adjacent to the corresponding first edge 101. An additional region 120 is arranged between the two first sub-regions 111. The reinforced limiting adhesive dot 310 is arranged in the adhesion-enhanced region, and the additional limiting adhesive dot 320 is arranged in the additional region 120. An adhesion force between the reinforced limiting adhesive dot 310 and the solder strip 200 is greater than that between the additional limiting adhesive dot 320 and the solder strip 200.

It should be understood that by arranging the reinforced limiting adhesive dot 310 in the first sub-region 111, the bonding strength between the end portion of the solder strip 200 and the edge of the cell substrate 100 can be enhanced. This design can ensure stable bonding between the end portion of the solder strip 200 and the edge of the cell substrate 100, and solve the issue of the loose connection caused by the gravity of the solar cell itself, thereby reducing the rework workload for the solar cell.

Referring to FIG. 1, in some examples of the embodiment, at least one of the first sub-regions 111 is provided with the reinforced limiting adhesive dot 310. Further, in an example, both the first sub-regions 111 are each provided with the reinforced limiting adhesive dot 310. By providing each of the two first sub-regions 111 with the reinforced limiting adhesive dot 310, the bonding strength between the solder strip 200 and each of the two opposite first edges 101 of the cell substrate 100 can be enhanced. Moreover, since the additional region 120 is located between the two first sub-regions 111, this design can also ensure stable adhesion between the solder strip 200 and the cell substrate 100 in the additional region 120.

Referring to FIG. 1, in some examples of the embodiment, each solder strip 200 is attached with the additional limiting adhesive dot 320 and at least two reinforced limiting adhesive dots 310, with the additional limiting adhesive dot 320 arranged between the two reinforced limiting adhesive dots 310, and the two reinforced limiting adhesive dots 310 located in the two first sub-regions 111, respectively. Therefore, the adhesion force between the solder strip 200 and each of the two first sub-regions 111 can be enhanced, and meanwhile due to the protection from the reinforced limiting adhesive dots 310 located on two end portions of the solder strip 200, the portion of the solder strip 200 located in the additional region 120 can withstand stronger pulling force. Therefore, even that the adhesion force between the additional limiting adhesive dot 320 and the solder strip 200 is lower, the portion of the solder strip 200 in the additional region 120 can still achieve stable adhesion with the cell substrate 100.

Referring to FIG. 1, in the embodiment, a plurality of reinforced limiting adhesive dots 310 and a plurality of additional limiting adhesive dots 320 collectively form an array of adhesive dots arranged in the first direction and the second direction. According to the orientation shown in FIG. 1, two rows of adhesive dots, a first row (a top row) and a last row (a bottom row), may be arranged in the two first sub-regions 111, respectively. These two rows of adhesive dots consist of the reinforced limiting adhesive dots 310.

It should be understood that in the embodiment shown in FIG. 1, each of the first sub-regions 111 is provided with one row of reinforced limiting adhesive dots 310. However, in alternative embodiments, each of the first sub-regions 111 may be provided with multiple rows of reinforced limiting adhesive dots 310. For example, one of the first sub-regions 111 may be further provided with one or more rows of reinforced limiting adhesive dots 310 located immediately proximate to the first row, and the other of the first sub-regions 111 may be further provided with one or more rows of reinforced limiting adhesive dots 310 located immediately proximate to the last row. Therefore, the adhesion force between the entire solder strip 200 and the cell substrate 100 can be further enhanced.

It should be understood that the reinforced limiting adhesive dot 310 and the additional limiting adhesive dot 320 may be made of the same adhesive material, so that they may be prepared simultaneously in the same preparation process using the same raw material. In some examples of the embodiment, a contact area between the reinforced limiting adhesive dot 310 and the solder strip 200 is greater than that between the additional limiting adhesive dot 320 and the solder strip 200, such that the adhesion force between the reinforced limiting adhesive dot 310 and the solder strip 200 is greater than that between the additional limiting adhesive dot 320 and the solder strip 200. It should be understood that the contact area between the limiting adhesive dot and the solder strip 200 may be controlled by the amount of adhesive applied. This design allows the reinforced limiting adhesive dot 310 and the additional limiting adhesive dot 320 to be prepared based on existing processes and production lines, and simplifies the actual preparation process of the reinforced limiting adhesive dot 310 and the additional limiting adhesive dot 320.

Further, in an example, a volume of the reinforced limiting adhesive dot 310 may be greater than that of the additional limiting adhesive dot 320, resulting in a larger contact area between the reinforced limiting adhesive dot 310 and the solder strip 200. The reinforced limiting adhesive dot 310 and the additional limiting adhesive dot 320 may be prepared using screen printing. It should be understood that in the screen printing process, the volume of the adhesive dot is related to a size of mesh openings in the screen printing plate. Therefore, it is only necessary to redesign the screen printing plate based on the conventional technology to complete the preparation of the reinforced limiting adhesive dot 310 and the additional limiting adhesive dot 320 in this example. Therefore, the design in this example has a high degree of compatibility with devices and processes in the conventional technology, a low implementation difficulty, and a high practical value.

FIG. 2 is a schematic view of a partially enlarged structure including the solder strip 200, the reinforced limiting adhesive dot 310, and the additional limiting adhesive dot 320 in FIG. 1. Referring to FIG. 2, the reinforced limiting adhesive dot 310 has a length *l₁* and a width *w₁*, where the length *l₁* is greater than the width *w₁*. The additional limiting adhesive dot 320 has a length *l₀* and a width *w₀*, where the length *l₀* is greater than the width *w₀*. It should be understood that in the embodiment shown in FIG. 1, the length *l₁* of the reinforced limiting adhesive dot 310 refers to a distance between two ends of the reinforced limiting adhesive dot 310 in the second direction, and the width *w₁* of the reinforced limiting adhesive dot 310 refers to a distance between two ends of the reinforced limiting adhesive dot 310 in the first direction. Further, the reinforced limiting adhesive dot 310 has a height (not shown in the figure) in a direction perpendicular to a surface of the cell substrate 100. The additional limiting adhesive dot 320 also has a height. For the length *l₀,* the width *w₀*, and the height of the additional limiting adhesive dot 320, reference is made to the above descriptions for corresponding understandings.

In some examples of the embodiment, a ratio of the length *l₁* of the reinforced limiting adhesive dot 310 to the length *l₀* of the additional limiting adhesive dot 320 is 1.2 to 2.

In some examples of the embodiment, a ratio of the width *w₁* of the reinforced limiting adhesive dot 310 to the width *w₀* of the additional limiting adhesive dot 320 is 1.2 to 2.

In some examples of the embodiment, a ratio of the height of the reinforced limiting adhesive dot 310 to the height of the additional limiting adhesive dot 320 is 1 to 2.

In the above examples, by designing the lengths, the widths, and the heights of the reinforced limiting adhesive dot 310 and the additional limiting adhesive dot 320, the adhesion force between the reinforced limiting adhesive dot 310 and the solder strip 200 can be better matched with the adhesion force between the additional limiting adhesive dot 320 and the solder strip 200, thereby further improving the bonding strength between the entire solder strip 200 and the cell substrate 100 and ensuring stable adhesion between the entire solder strip 200 and the cell substrate 100.

Referring to FIG. 2, the solder strip 200 has a strip width d, and the strip width refers to a distance between two ends of the solder strip 200 in the second direction.

In some examples of the embodiment, a ratio of the length *l₀* of the additional limiting adhesive dot 320 to the strip width d of the solder strip 200 is 1.5 to 6.

In some examples of the embodiment, a ratio of the width *w₀* of the additional limiting adhesive dot 320 to the strip width d of the solder strip 200 is 0.5 to 3.

In some examples of the embodiment, a ratio of the height of the additional limiting adhesive dot 320 to the strip width d of the solder strip is 0.5 to 1.2.

In the above examples, by designing the length, the width, and the height of the additional limiting adhesive dot 320, the volume of the additional limiting adhesive dot 320 can be better matched with the strip width of the solder strip 200, thereby ensuring stable adhesion between the solder strip 200 and the cell substrate 100 while minimizing material consumption and reducing a shading area of the additional limiting adhesive dot 320, and thus improving the amount of light received by the cell substrate 100.

In the embodiment, the cell substrate 100 is a cell substrate without a main grid electrode. Referring to FIG. 1, in some examples of the embodiment, the cell substrate 100 may include a welding electrode (not shown in the figure). The welding electrode is arranged below the solder strip 200 and extends in an extension direction of the solder strip 200. In an example, a width of the welding electrode is 50 µm to 55 µm.

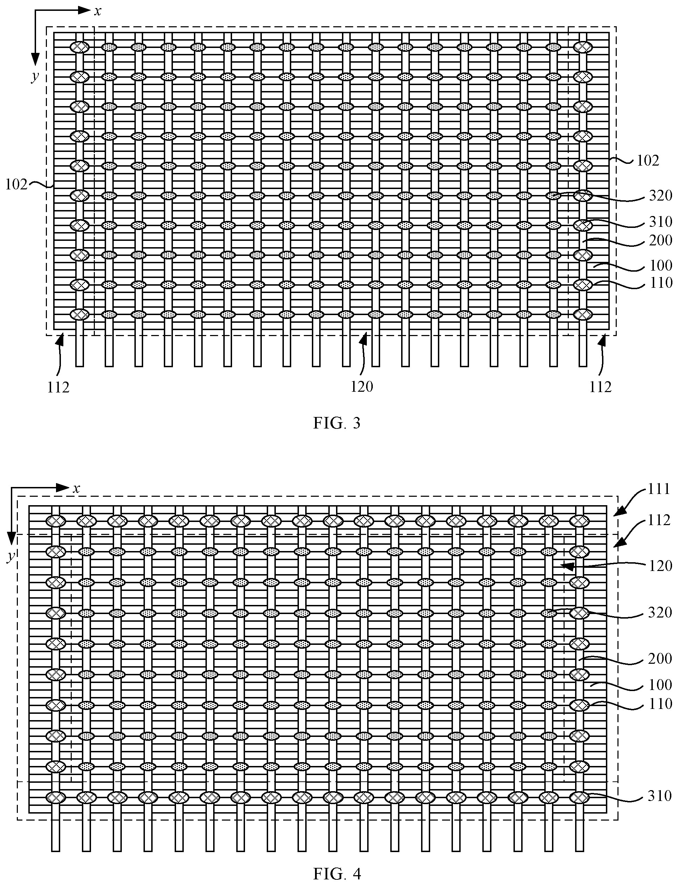

FIG. 3 is a schematic top view of a structure of a solar cell according to an embodiment. Referring to FIG. 3, the solar cell includes a cell substrate 100, a solder strip 200, and a plurality of limiting adhesive dots. The solder strip 200 is arranged on the cell substrate 100. The reinforced limiting adhesive dot 310 and the additional limiting adhesive dot 320 are attached to the solder strip 200 and the cell substrate 100. In some examples of the embodiment, there may be a plurality of solder strips 200 extending in a first direction and arranged side by side in a second direction intersecting with the first direction. For ease of description, the first direction may be a direction indicated by a y-axis in FIG. 3, and the second direction may be a direction indicated by an x-axis in FIG. 3. In some examples, the first direction and the second direction intersect perpendicularly.

In the embodiment, the cell substrate 100 has two second edges 102 opposite to each other in the second direction. It should be understood that according to the orientation shown in FIG. 3, the two second edges 102 are located on a left side and a right side of the cell substrate 100, respectively. Further, an adhesion-enhanced region may include two second sub-regions 112 located immediately adjacent to the two second edges 102, respectively. Each second sub-region 112 may be located immediately adjacent to the corresponding entire second edge 102. An additional region 120 is arranged between the two second sub-regions 112. The additional limiting adhesive dot 310 is arranged in the additional region 120, and the reinforced limiting adhesive dot 310 is arranged in the adhesion-enhanced region. The adhesion force between the reinforced limiting adhesive dot 310 and the solder strip 200 is greater than that between the additional limiting adhesive dot 320 and the solder strip 200.

It should be understood that by arranging the reinforced limiting adhesive dot 310 in the second sub-region 112, the overall bonding strength between the edge of the cell substrate 100 and the solder strip 200 thereon can be enhanced. This design can ensure stable bonding between the edge of the cell substrate 100 and the portion of the solder strip 200 located at the edge, and solve the problem of loose connection caused by the pushing force exerted by the flowing of a molten encapsulation film, thereby further improving the reliability of the solar cell after the solar cell is prepared into a module.

Referring to FIG. 3, in some examples of the embodiment, at least one of the second sub-regions 112 is provided with the reinforced limiting adhesive dot 310. Further, in an example, both the second sub-regions 112 are each provided with the reinforced limiting adhesive dot 310. The portion of the solder strip 200 located at the outermost side is subjected to a relatively large pushing force. By providing each of the two second sub-regions 112 with the reinforced limiting adhesive dot 310, the flowing and filling of the molten encapsulant film between the solder strip 200 and the cell substrate 100 can be effectively avoided, thereby further improving the reliability of the solar cell.

Referring to FIG. 3, in some examples of the embodiment, each of the second sub-regions 112 is provided with at least one solder strip 200, and a plurality of reinforced limiting adhesive dots 310 are attached to the solder strip 200 arranged in the second sub-region 112.

Referring to FIG. 3, in the embodiment, the first solder strip 200 and the last solder strip 200 in the second direction are respectively arranged in the two second sub-regions 112. The first solder strip 200 and the last solder strip 200 are each attached with a plurality of reinforced limiting adhesive dots 310 sequentially arranged in the first direction.

Further, referring to FIG. 3, in the embodiment, a plurality of reinforced limiting adhesive dots 310 and a plurality of additional limiting adhesive dots 320 collectively form an array of adhesive dots in the first direction and the second direction. According to the orientation shown in FIG. 3, two columns of adhesive dots, a first column (a leftmost column) and a last column (a rightmost column), may be respectively arranged on the two second sub-regions 112. These two columns of adhesive dots consist of the reinforced limiting adhesive dots 310.

It should be understood that in the embodiment as shown in FIG. 3, each of the second sub-regions 112 is provided with one column of reinforced limiting adhesive dots 310. However, in alternative embodiments, each of the second sub-regions 112 may be provided with multiple columns of reinforced limiting adhesive dots 310. For example, one of the second sub-regions 112 may be further provided with one or more columns of reinforced limiting adhesive dots 310 located immediately proximate to the first column, and the other of the second sub-regions 112 may be further provided with one or more columns of reinforced limiting adhesive dots 310 located immediately proximate to the last column. Therefore, the adhesion force between the entire solder strip 200 and the cell substrate 100 can be further enhanced.

In some examples of the embodiment, a contact area between the reinforced limiting adhesive dot 310 and the solder strip 200 is greater than a contact area between the additional limiting adhesive dot 320 and the solder strip 200, such that the adhesion force between the reinforced limiting adhesive dot 310 and the solder strip 200 is greater than that between the additional limiting adhesive dot 320 and the solder strip 200. Further, in an example, a volume of the reinforced limiting adhesive dot 310 may be greater than that of the additional limiting adhesive dot 320, resulting in a larger contact area between the reinforced limiting adhesive dot 310 and the solder strip 200.

A main difference between the embodiment shown in FIG. 3 and the embodiment shown in FIG. 1 lies in the design of the position of the adhesion-enhanced region and the design of the position of the corresponding reinforced limiting adhesive dot 310. For a specific size design of the reinforced limiting adhesive dot 310 and the additional limiting adhesive dot 320 in the embodiment shown in FIG. 3, reference may be made to the description in connection with FIG. 1 above, which will not be repeated herein.

FIG. 4 is a schematic top view of a structure of a solar cell according to an embodiment. Referring to FIG. 4, the solar cell includes a cell substrate 100, a solder strip 200, a reinforced limiting adhesive dot 310, and an additional limiting adhesive dot 320. The solder strip 200 is arranged on the cell substrate 100. The reinforced limiting adhesive dot 310 and the additional limiting adhesive dot 320 are attached to the solder strip 200 and the cell substrate 100.

In some examples of the embodiment, there may be a plurality of solder strips 200, and the plurality of solder strips 200 extend in a first direction and are arranged side by side in a second direction intersecting with the first direction. For ease of description, the first direction may be a direction indicated by a y-axis in FIG. 4, and the second direction may be a direction indicated by an x-axis in FIG. 4. In some examples, the first direction and the second direction intersect perpendicularly.

In the embodiment, the cell substrate 100 has two first edges 101 opposite to each other in the first direction, and two second edges 102 opposite to each other in the second direction. Further, an adhesion-enhanced region may include two first sub-regions 111 located immediately adjacent to the two first edges 101, respectively, and two second sub-regions 112 located immediately adjacent to the two second edges 102, respectively. Referring to FIG. 4, the two first sub-regions 111 and the two second sub-regions 112 form an annular region, and an additional region 120 is located at an inner side of the annular region. The additional limiting adhesive dot 320 is arranged in the additional region 120, and the reinforced limiting adhesive dot 310 is arranged in the adhesion-enhanced region. An adhesion force between the reinforced limiting adhesive dot 310 and the solder strip 200 is greater than that between the additional limiting adhesive dot 320 and the solder strip 200.

It should be understood that by providing each of the first sub-regions 111 and the second sub-regions 112 with the reinforced limiting adhesive dot 310, both the problem of loose connection caused by the gravity of the solar cell itself and the problem of loose connection caused by the pushing force exerted by the flowing of the molten encapsulant film can be solved, thereby effectively reducing the rework workload for the solar cell, effectively enhancing the reliability of the module formed by the solar cell, and significantly reducing the occurrence rate of edge shading problems in the solar cell during electroluminescence (EL) testing.

Referring to FIG. 4, in some examples of the embodiment, each of the second sub-regions 112 is provided with at least one solder strip 200, and a plurality of reinforced limiting adhesive dots 310 are attached to the solder strip 200 arranged in the second sub-region 112. Moreover, the solder strip 200 located between the two second sub-regions 112 is attached with the additional limiting adhesive dot 320 and at least two reinforced limiting adhesive dots 310, with the additional limiting adhesive dot 320 arranged between the two reinforced limiting adhesive dots 310, and the two reinforced limiting adhesive dots 310 located in the two first sub-regions 111, respectively.

Referring to FIG. 4, in the embodiment, a plurality of reinforced limiting adhesive dots 310 and a plurality of additional limiting adhesive dots 320 collectively form an array of adhesive dots in the first direction and the second direction. According to the orientation shown in FIG. 4, the outermost ring of adhesive dots consists of the reinforced limiting adhesive dots 310.

It should be understood that in the embodiment as shown in FIG. 4, each of the first sub-regions 111 is provided with one row of reinforced limiting adhesive dots 310, and each of the second sub-regions 112 is provided with one column of reinforced limiting adhesive dots 310. However, in alternative embodiments, each of the first sub-regions 111 may be provided with multiple rows of reinforced limiting adhesive dots 310, or each of the second sub-regions 112 may be provided with multiple columns of reinforced limiting adhesive dots 310.

In the embodiment shown in FIG. 4, the adhesion force between the reinforced limiting adhesive dot 310 and the solder strip 200 in the first sub-region 111 may be equal to the adhesion force between the reinforced limiting adhesive dot 310 and the solder strip 200 in the second sub-region 112.

A main difference between the embodiment shown in FIG. 4 and the embodiment shown in FIG. 1 lies in the design of the position of the adhesion-enhanced region and the design of position of the corresponding reinforced limiting adhesive dot 310. For a specific size design of the reinforced limiting adhesive dot 310 and the additional limiting adhesive dot 320 in the embodiment shown in FIG. 4, reference may be made to the description in connecting with FIG. 1 above, which will not be repeated herein.

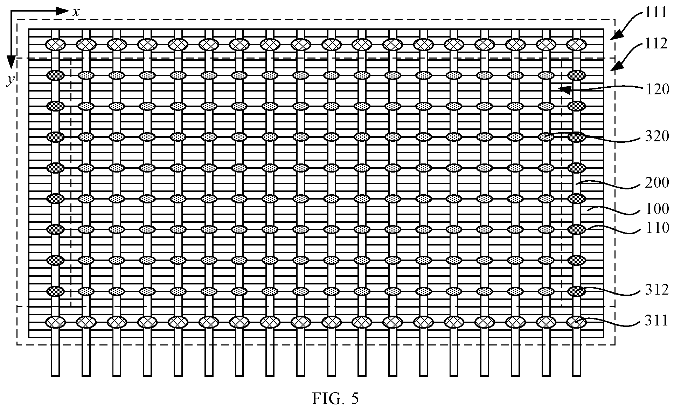

FIG. 5 is a schematic top view of a structure of a solar cell according to an embodiment. Referring to FIG. 5, the solar cell includes a cell substrate 100, a solder strip 200, a reinforced limiting adhesive dot 310, and an additional limiting adhesive dot 320. The solder strip 200 is arranged on the cell substrate 100. The reinforced limiting adhesive dot 310 and the additional limiting adhesive dot 320 are attached to the solder strip 200 and the cell substrate 100.

Referring to FIG. 5, an adhesion-enhanced region in FIG. 5 also includes first sub-regions 111 and second sub-regions 112. Each of the first sub-regions 111 and the second sub-regions 112 is provided with the reinforced limiting adhesive dot 310. The arrangement of the reinforced limiting adhesive dot 310 is similar to that in the embodiment shown in FIG. 4, which will not be repeated herein.

Different from the embodiment shown in FIG. 4, the reinforced limiting adhesive dot 310 in the embodiment shown in FIG. 5 include a first reinforced adhesive dot 311 and a second reinforced adhesive dot 312. The first reinforced adhesive dot 311 is located in the first sub-region 111, and the second reinforced adhesive dot 312 is located in the second sub-region 112. The adhesion force between the first reinforced adhesive dot 311 and the solder strip 200 is different from the adhesion force between the second reinforced adhesive dot 312 and the solder strip 200.

In some examples of the embodiment, a volume of the first reinforced adhesive dot 311 is greater than that of the second reinforced adhesive dot 312. For example, the first reinforced adhesive dot 311 and the second reinforced adhesive dot 312 satisfy at least one of the following features: a length of the first reinforced adhesive dot 311 differs from a length of the second reinforced adhesive dot 312, a width of the first reinforced adhesive dot 311 differs from a width of the second reinforced adhesive dot 312, and a height of the first reinforced adhesive dot 311 differs from a height of the second reinforced adhesive dot 312.

In some examples of the embodiment, the length of the first reinforced adhesive dot 311 is greater than that of the second reinforced adhesive dot 312.

In some examples of the embodiment, the width of the first reinforced adhesive dot 311 is greater than that of the second reinforced adhesive dot 312.

In some examples of the embodiment, the height of the first reinforced adhesive dot 311 is greater than that of the second reinforced adhesive dot 312.

The present inventors have found through the further research that, in the extension direction of the solder strip 200, i.e., in the first direction, establishing a larger direct adhesion force between the limiting adhesive dots at both ends and the solder strip 200 can enhance the bonding strength between the entire solder strip 200 and the cell substrate 100. Therefore, on the basis of the provision of the first reinforced adhesive dot 311, by appropriately reducing the volume of the second reinforced adhesive dot 312, the bonding strength between the entire solder strip 200 and the cell substrate 100 can still be maintained, while also facilitating a reduction in material consumption and the shading area of the limiting adhesive dots.

FIG. 1 and FIG. 2-5 illustrate various specific embodiments proposed based on the technical concept of the present application, but specific implementations of the present application are not limited to the above embodiments.

In a second aspect, the present disclosure further provides a solar cell string, including a plurality of solar cells according to any one of the above embodiments, with the solder strips of the solar cells connected to each other.

In a third aspect, the present disclosure further provides a photovoltaic module, including a first encapsulation panel, a second encapsulation panel, and the solar cell string according to any one of the above embodiments. The solar cell string is arranged between the first encapsulation panel and the second encapsulation panel.

To further illustrate the implementations and technical effects of the present disclosure in detail, the following further examples and comparative examples are provided in the present disclosure.

### Example 1

A cell substrate without a main grid electrode was provided. A plurality of fine grid electrodes extending in a second direction was disposed on the cell substrate. A plurality of solder strips extending in a first direction was disposed on the cell substrate. The solder strips were welded to the fine grid electrodes on the cell substrate.

Based on a structure similar to that shown in FIG. 1, a plurality of limiting adhesive dots arranged in an array was screen-printed onto the cell substrate, with a first row of limiting adhesive dots and a last row of limiting adhesive dots arranged in a transverse direction (i.e., a direction transverse to the first direction, e.g., the second direction) printed as reinforced limiting adhesive dots, and the other limiting adhesive dots located between the first row of limiting adhesive dots and the last row of limiting adhesive dots printed as additional limiting adhesive dots. The reinforced limiting adhesive dots were designed to have a length that was 9 times the strip width of the solder strips, a width that was 4.5 times the strip width of the solder strips, and a height that was 1.2 times the strip width of the solder strips. The additional limiting adhesive dots were designed to have a length that was 6 times the strip width of the solder strips, a width that was 2 times the strip width of the solder strips, and a height that was 0.8 times the strip width of the solder strips.

### Example 2

A cell substrate without a main grid electrode was provided. A plurality of fine grid electrodes extending in a second direction was disposed on the cell substrate. A plurality of solder strips extending in a first direction was disposed on the cell substrate. The solder strips were welded to the fine grid electrodes on the cell substrate.

Based on a structure similar to that shown in FIG. 3, a plurality of limiting adhesive dots arranged in an array was screen-printed onto the cell substrate, with a first column of limiting adhesive dots and a last column of limiting adhesive dots arranged in a longitudinal direction (i.e., the extension direction of the solder strips, e.g., the first direction) printed as reinforced limiting adhesive dots, and the other limiting adhesive dots located between the first column of limiting adhesive dots and the last column of limiting adhesive dots printed as additional limiting adhesive dots. The reinforced limiting adhesive dots were designed to have a length that was 9 times the strip width of the solder strips, a width that was 4.5 times the strip width of the solder strips, and a height that was 1.2 times the strip width of the solder strips. The additional limiting adhesive dots were designed to have a length that was 6 times the strip width of the solder strips, a width that was 2 times the strip width of the solder strips, and a height that was 0.8 times the strip width of the solder strips.

### Example 3

A cell substrate without a main grid electrode was provided. A plurality of fine grid electrodes extending in a second direction was disposed on the cell substrate. A plurality of solder strips extending in a first direction was disposed on the cell substrate. The solder strips were welded to the fine grid electrodes on the cell substrate.

Based on a structure similar to that shown in FIG. 4, a plurality of limiting adhesive dots arranged in an array was screen-printed onto the cell substrate. The outermost ring of limiting adhesive dots were printed as reinforced limiting adhesive dots. In other words, a first row of limiting adhesive dots, a last row of limiting adhesive dots, a first column of limiting adhesive dots, and a last column of limiting adhesive dots were printed as reinforced limiting adhesive dots. The other limiting adhesive dots enclosed by the reinforced limiting adhesive dots were printed as additional limiting adhesive dots. The reinforced limiting adhesive dots were designed to have a length that was 9 times the strip width of the solder strips, a width that was 4.5 times the strip width of the solder strips, and a height that was 1.2 times the strip width of the solder strips. The additional limiting adhesive dots were designed to have a length that was 6 times the strip width of the solder strips, a width that was 2 times the strip width of the solder strips, and a height that was 0.8 times the strip width of the solder strips.

### Example 4

A cell substrate without a main grid electrode was provided. A plurality of fine grid electrodes extending in a second direction was disposed on the cell substrate. A plurality of solder strips extending in a first direction was disposed on the cell substrate. The solder strips were welded to the fine grid electrodes on the cell substrate.

Based on a structure similar to that shown in FIG. 5, a plurality of limiting adhesive dots arranged in an array was screen-printed onto the cell substrate. The outermost ring of limiting adhesive dots were printed as reinforced limiting adhesive dots, with a first row of limiting adhesive dots and a last row of limiting adhesive dots arranged in a transverse direction (i.e., a direction transverse to the first direction, e.g., the second direction) as first reinforced adhesive dots, and a first column of limiting adhesive dots and a last column of limiting adhesive dots arranged in a longitudinal direction (i.e., the extension direction of the solder strips, e.g., the first direction) as second reinforced adhesive dots. The other limiting adhesive dots enclosed by the reinforced limiting adhesive dots were printed as additional limiting adhesive dots. The first reinforced adhesive dots were designed to have a length that was 9 times the strip width of the solder strips, a width that was 4.5 times the strip width of the solder strips, and a height that was 1.2 times the strip width of the solder strips. The second reinforced adhesive dots were designed to have a length that was 8 times the strip width of the solder strips, a width that was 4 times the strip width of the solder strips, and a height that was 1 time the strip width of the solder strips. The additional limiting adhesive dots were designed to have a length that was 6 times the strip width of the solder strips, a width that was 2 times the strip width of the solder strips, and a height that was 0.8 times the strip width of the solder strips.

### Comparative Example 1

A cell substrate without a main grid electrode was provided. A plurality of fine grid electrodes extending in a second direction was disposed on the cell substrate. A plurality of solder strips extending in a first direction was disposed on the cell substrate. The solder strips were welded to the fine grid electrodes on the cell substrate.

Based on a structure similar to that shown in FIG. 1, a plurality of limiting adhesive dots arranged in an array was screen-printed onto the cell substrate, with all of the limiting adhesive dots designed to have the same size. The limiting adhesive dots were designed to have a length that was 6 times the strip width of the solder strips, a width that was 2 times the strip width of the solder strips, and a height that was 0.8 times the strip width of the solder strips.

### Comparative Example 2:

A cell substrate without a main grid electrode was provided. A plurality of fine grid electrodes extending in a second direction was disposed on the cell substrate. A plurality of solder strips extending in a first direction was disposed on the cell substrate. The solder strips were welded to the fine grid electrodes on the cell substrate.

Based on a structure similar to that shown in FIG. 1, a plurality of limiting adhesive dots arranged in an array was screen-printed onto the cell substrate, with all of the limiting adhesive dots designed to have the same size. The limiting adhesive dots were designed to have a length that was 9 times the strip width of the solder strips, a width that was 4.5 times the strip width of the solder strips, and a height that was 1.2 times the strip width of the solder strips.

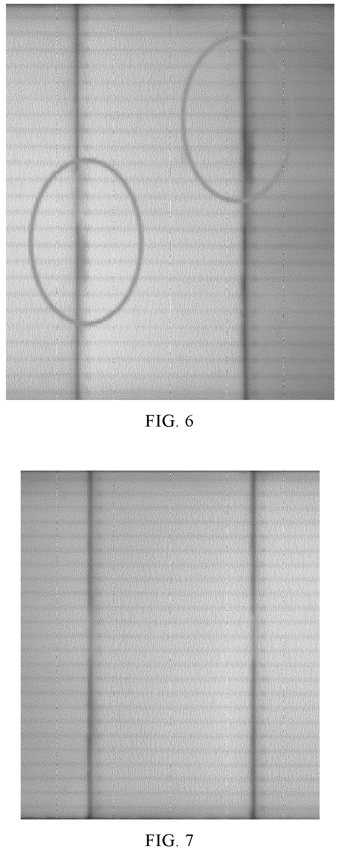

Experiment Example 1: The solar cells in Example 1 and Comparative Example 1 were prepared into solar cell strings for electroluminescence testing. The test results for Comparative Example 1 are shown in FIG. 6, and the test results for Example 1 are shown in FIG. 7.

Experiment Example 2: The solar cells in Examples and Comparative Examples were prepared into photovoltaic modules. The photovoltaic modules were tested for module power (Pₘₐₓ), open-circuit voltage (V_{oc}), short-circuit current (I_{sc}), fill factor (FF), and efficiency (Eₜₐ), and the results are shown in Table 1.

**Table 1**

| | Pₘₐₓ (W) | V_{oc} (V) | I_{sc} (A) | FF | Eₜₐ |
|---|---|---|---|---|---|
| Example 1 | 700.8 | 43.384 | 18.178 | 79.68% | 22.56% |
| Example 2 | 699.5 | 48.385 | 18.162 | 79.60% | 22.52% |
| Example 3 | 701.1 | 48.384 | 18.182 | 79.70% | 22.57% |
| Example 4 | 701.3 | 48.385 | 18.185 | 79.71% | 22.58% |
| Comparative Example 1 | 693.9 | 48.383 | 18.122 | 79.14% | 22.34% |
| Comparative Example 2 | 698.4 | 48.384 | 18.145 | 79.55% | 22.48% |

As shown in FIG. 6, obvious dark zones (which have been indicated by circles in FIG. 6) appear at the edge areas of the solar cells in Comparative Example 1 (i.e., appear at two sides of the junction between two adjacent solar cells) during the electroluminescence testing, indicating an issue of loose connections in those zones. In contrast, as shown in FIG. 7, there are substantially no dark zones at the edge areas of the solar cells in Example 1 during the electroluminescence testing, indicating that the solar cell string prepared in Example 1 effectively addresses the issue of loose connections.

As shown in Table 1, compared to the photovoltaic module in Comparative Example 1, the photovoltaic modules in Example 1 to 4 demonstrate significant improvements in various performance metrics, including module power, open-circuit voltage, short-circuit current, fill factor, and conversion efficiency. This suggests that arrangement of the larger reinforced limiting adhesive dots in the adhesion-enhanced region and the smaller additional limiting adhesive dots in the additional region, as described in the present disclosure, can effectively resolve the loose connection issue and enhance the electrical performance of the module. In Comparative Example 2, larger reinforced limiting adhesive dots are applied across the entire surface of the cell substrate; while this method can address the loose connection issue, it results in reduced module power and conversion efficiency, probably because the presence of larger reinforced limiting adhesive dots may decrease the actual amount of light received by the cell substrate, thereby reducing both module power and conversion efficiency.

Furthermore, the short-circuit current in Example 1 is significantly higher than that in Example 2. This is primarily because, in Example 1, the reinforced limiting adhesive dots are arranged at both the head and tail ends of each of the solder strips, whereas in Example 2, the reinforced limiting adhesive dots are only arranged on the edge solder strips. This indicates that reinforcing the head and tail ends of each of the solder strips is more effective than merely reinforcing the edge solder strips. In Example 3, the reinforced limiting adhesive dots are arranged at the head and tail ends of each of the solder strips as well as on the edge solder strips, resulting in a further increase in power compared to Example 1. In Example 4, the reinforced limiting adhesive dots are further categorized into first and second reinforced adhesive dots, leading to an additional increase in power compared to Example 3.

It should be understood that unless explicitly stated in this specification, there are no strict order limitations on the execution of the steps, and these steps may be performed in another order. Moreover, at least some of the steps in the preparation process may include a plurality of substeps or a plurality of stages. These substeps or stages may not be necessarily completed at the same time but may be performed at different times. These substeps or stages are not necessarily performed in sequence, but may be performed alternately or in rotation with other steps or at least some of the substeps or stages in other steps.

The various embodiments in the specification are described in a progressive manner, with each embodiment highlighting the differences from other embodiments. The identical or similar parts between the various embodiments may be cross-referenced to each other.

## Claims

1. A solar cell, comprising a cell substrate (100), a solder strip (200), a reinforced limiting adhesive dot (310), and an additional limiting adhesive dot (320),
wherein the solder strip is arranged on the cell substrate, and the reinforced limiting adhesive dot and the additional limiting adhesive dot are attached to the solder strip and the cell substrate; and
wherein the cell substrate comprises an adhesion-enhanced region and an additional region (120), the adhesion-enhanced region is immediately adjacent to at least one edge of the cell substrate, the additional region is arranged at a side of the adhesion-enhanced region away from the at least one edge, the additional limiting adhesive dot is arranged in the additional region, the reinforced limiting adhesive dot is arranged in the adhesion-enhanced region, and an adhesion force between the reinforced limiting adhesive dot and the solder strip is greater than that between the additional limiting adhesive dot and the solder strip.

2. The solar cell according to claim 1, wherein a contact area between the reinforced limiting adhesive dot and the solder strip is greater than that between the additional limiting adhesive dot and the solder strip, such that the adhesion force between the reinforced limiting adhesive dot and the solder strip is greater than that between the additional limiting adhesive dot and the solder strip.

3. The solar cell according to claim 1 or 2, wherein a volume of the reinforced limiting adhesive dot is greater than that of the additional limiting adhesive dot.

4. The solar cell according to any one of claims 1 to 3, wherein a length of the reinforced limiting adhesive dot is greater than that of the additional limiting adhesive dot, a width of the reinforced limiting adhesive dot is greater than that of the additional limiting adhesive dot, and a height of the reinforced limiting adhesive dot is greater than that of the additional limiting adhesive dot.

5. The solar cell according to claim 4, wherein the additional limiting adhesive dot and the reinforced limiting adhesive dot satisfy at least one of the following conditions:
(1) a ratio of the length of the reinforced limiting adhesive dot to the length of the additional limiting adhesive dot is 1.2 to 2;
(2) a ratio of the width of the reinforced limiting adhesive dot to the width of the additional limiting adhesive dot is 1.2 to 2; and
(3) a ratio of the height of the reinforced limiting adhesive dot to the height of the additional limiting adhesive dot is 1 to 2.

6. The solar cell according to any one of claims 1 to 5, wherein the additional limiting adhesive dot satisfy at least one of the following conditions:
(1) a ratio of the length of the additional limiting adhesive dot to a strip width of the solder strip is 1.5 to 6;
(2) a ratio of the width of the additional limiting adhesive dot to the strip width of the solder strip is 0.5 to 3; and
(3) a ratio of the height of the additional limiting adhesive dot to the strip width of the solder strip is 0.5 to 1.2.

7. The solar cell according to any one of claims 1 to 6, wherein there are a plurality of solder strips extending in a first direction and arranged side by side in a second direction intersecting with the first direction, and the at least one edge of the cell substrate comprises two first edges (101) opposite to each other in the first direction and two second edges (102) opposite to each other in the second direction;
wherein the adhesion-enhanced region comprises two first sub-regions (111) located immediately adjacent to the two first edges, respectively, and at least one of the two first sub-regions is provided with the reinforced limiting adhesive dot, or
the adhesion-enhanced region comprises two second sub-regions (112) located immediately adjacent to the two second edges, respectively, and at least one of the two second sub-region is provided with the reinforced limiting adhesive dot.

8. The solar cell according to claim 7, wherein the adhesion-enhanced region comprises the two first sub-regions, each of the plurality of solder strips is attached with the additional limiting adhesive dot and at least two reinforced limiting adhesive dots, the additional limiting adhesive dot is arranged between the two reinforced limiting adhesive dots, and the two reinforced limiting adhesive dots are located in the two first sub-regions, respectively; or
the adhesion-enhanced region comprises the two second sub-regions, each of the two second sub-regions is provided with at least one solder strip, and each of the at least one solder strip in each of the two second sub-regions is attached with a plurality of reinforced limiting adhesive dots.

9. The solar cell according to claim 7, wherein the adhesion-enhanced region comprises the two first sub-regions and the two second sub-regions, and the two second sub-regions are located between the two first sub-regions;
wherein each of the two first sub-regions is provided with at least one solder strip, and each of the at least one solder strip in each of the two second sub-regions is attached with a plurality of reinforced limiting adhesive dots; and
the solder strip located between the two second sub-regions is attached with the additional limiting adhesive dot and at least two reinforced limiting adhesive dots, the additional limiting adhesive dot is arranged between the two reinforced limiting adhesive dots, and the two reinforced limiting adhesive dots are located in the two first sub-regions, respectively.

10. The solar cell according to claim 9, wherein the plurality of reinforced limiting adhesive dots comprise a first reinforced adhesive dot (311) arranged in the first sub-region and a second reinforced adhesive dot (312) arranged in the second sub-region, and an adhesion force between the first reinforced adhesive dot and the solder strip is greater than that between the second reinforced adhesive dot and the solder strip.

11. The solar cell according to claim 10, wherein the first reinforced adhesive dot and the second reinforced adhesive dot satisfy at least one of the following conditions:
(1) a length of the first reinforced adhesive dot is greater than that of the second reinforced adhesive dot;
(2) a width of the first reinforced adhesive dot is greater than that of the second reinforced adhesive dot; and
(3) a height of the first reinforced adhesive dot is greater than that of the second reinforced adhesive dot.

12. The solar cell according to any one of claims 1 to 11, wherein the cell substrate comprises a welding electrode arranged below the solder strip and extending in an extension direction of the solder strip, and a width of the welding electrode is 50 µm to 55 µm.

13. The solar cell according to any one of claims 1 to 12, wherein a material of the reinforced limiting adhesive dot is the same as that of the additional limiting adhesive dot.

14. A solar cell string, comprising a plurality of solar cells according to any one of claims 1 to 13, wherein the solar cells are connected by the solder strips thereof.

15. A photovoltaic module, comprising a first encapsulation panel, a second encapsulation panel, and the solar cell string according to claim 14, wherein the solar cell string is arranged between the first encapsulation panel and the second encapsulation panel.
